# EUROPEAN PATENT SPECIFICATION

(11) **EP 3 254 373 B1**
(45) Date of publication and mention of the grant of the patent: **21.11.2018**
(21) Application number: 16706944.2
(22) Date of filing: 08.02.2016
(51) Int. Cl.: H02S 50/00, H02S 50/10

(54) **PHOTOVOLTAIC STRING COMBINER WITH MODULAR PLATFORM ARCHITECTURE**
PHOTOVOLTAISCHER STRANGKOMBINATOR MIT MODULARER PLATTFORMARCHITEKTUR
COMBINEUR DE CHAÎNE PHOTOVOLTAÏQUE À ARCHITECTURE DE PLATE-FORME MODULAIRE

(30) Priority: 06.02.2015 US 201562112685 P
(43) Date of publication of application: 13.12.2017
(73) Proprietor: ABB Schweiz AG, 5400 Baden (CH)
(72) Inventor: WHITE, Paul, M., San Jose, CA 95112 (US); ALHOOR, Wisam, M, Phoenix, AZ 85281 (US)
(74) Representative: Gregorj S.r.l.
(86) International application number: PCT/US2016/016935
(87) International publication number: WO 2016/127154

(56) References cited:
- US-A1- 2012 053 867
- US-A1- 2012 253 533
- US-A1- 2012 310 427

## Description

### RELATED APPLICATIONS

This application claims priority to U.S. Provisional Application 62/112,685, titled "PHOTOVOLTAIC STRING COMBINER WITH MODULAR PLATFORM ARCHITECTURE" and filed on February 6, 2015.

### BACKGROUND

Many electric systems may utilize photovoltaic arrangements, such as photovoltaic systems comprising solar panels that absorb and convert sunlight into electricity for power generation. An inverter may be configured to convert DC power from a photovoltaic arrangement to AC power for an AC power grid that may supply power to a building. The photovoltaic arrangement may comprise a plurality of photovoltaic strings that may be combined in parallel by a photovoltaic string combiner. A photovoltaic string may comprise a plurality of photovoltaic panels that are connected in series. The photovoltaic string combiner may be configured to measure current and/or obtain other information from the photovoltaic strings such as identification of a fault. Unfortunately, photovoltaic string combiners may be designed with a particular number of connections used to connect to photovoltaic stings (e.g., photovoltaic string combiners may be massed produced with the same configuration or may be custom made which may be prohibitively expensive), and thus a photovoltaic string combiner may be underutilized or unable to scale to support larger numbers of photovoltaic strings. If a single component is changed (e.g., replacement of a failed string monitoring interface board within the photovoltaic string combiner), then an entire photovoltaic system may need to be updated and/or recalibrated (e.g., due to analog signals connecting through the entire photovoltaic system), which may result in costly field calibration and service.
An automatic monitoring and adjustment of a solar panel array is disclosed in document US 2012/0310427 A1.

### SUMMARY

This summary is provided to introduce a selection of concepts in a simplified form that are further described below in the detailed description. This summary is not intended to identify key factors or essential features of the claimed subject matter, nor is it intended to be used to limit the scope of the claimed subject matter.

Among other things, one or more systems and/or techniques for managing a photovoltaic arrangement are provided herein. A photovoltaic string combiner may be configured to combine, such as in parallel, a set of photovoltaic strings of a photovoltaic arrangement. A photovoltaic string may comprise a plurality of photovoltaic panels connected in series. The photovoltaic string combiner may comprise a modular platform architecture configured to host one or more monitoring modules interconnected by a communication channel. Because the modular platform architecture may be configured according to a drop in topology (e.g., front facing hardware used to interface with monitoring modules), a monitoring module may be easily installed or removed from the modular platform architecture. In an example, a monitoring module may have a digital configuration so that the monitoring module may be installed according to a plug and play configuration where the monitoring module may become self-ware of its operating configuration and/or role within the photovoltaic string combiner without manual recalibration the photovoltaic string combiner. The invention is as set forth in independent claims 1 and 14. Further advantageous embodiments are as recited in the dependent claims.

In an example, the one or more monitoring modules may comprise a first monitoring module comprising a local processor. The local processor may be configured to self-detect first positional data (e.g., an installed position of the first monitoring module within the modular platform architecture, such as a first installation slot connected to a first set of 10 photovoltaic strings within the photovoltaic arrangement) and/or configuration data (e.g., whether the first monitoring module is grounded or floating) of the first monitoring module. The first local processor may be configured to obtain measurement data from the first set of 10 photovoltaic string connected to the first monitoring module (e.g., current measurements, detection of a fault or failure, etc.). The photovoltaic string combiner may comprise a main controller module connected to the modular platform architecture by the communication channel. The main controller module may be configured to determine a state of the photovoltaic arrangement based upon positional data, configuration data, and/or measurement data received from the one or more monitoring modules installed within the modular platform architecture. In an example, the state may indicate whether a photovoltaic string has a fault or is operating according to spec. In another example, the state may indicate a modular configuration of the modular platform architecture (e.g., a number of photovoltaic strings connected to the photovoltaic arrangement, a number of monitoring modules installed within the modular platform architecture, whether a monitoring module is grounded or floating, an installation or a removal of a monitoring module, etc.).

To the accomplishment of the foregoing and related ends, the following description and annexed drawings set forth certain illustrative aspects and implementations. These are indicative of but a few of the various ways in which one or more aspects may be employed. Other aspects, advantages, and novel features of the disclosure will become apparent from the following detailed description when considered in conjunction with the annexed drawings.

### DESCRIPTION OF THE DRAWINGS

Fig. 1 is a component block diagram illustrating an exemplary system for managing a photovoltaic arrangement.
Fig. 2A is a component block diagram illustrating an exemplary system for managing a photovoltaic arrangement, where positional data and configuration data is provided to a main controller module.
Fig. 2B is a component block diagram illustrating an exemplary system for managing a photovoltaic arrangement, where measurement data is provided to a main controller module.
Fig. 2C is a component block diagram illustrating an exemplary system for managing a photovoltaic arrangement, where a monitoring module is removed from a module platform architecture.
Fig. 2D is a component block diagram illustrating an exemplary system for managing a photovoltaic arrangement, where data is locally shared between monitoring modules.
Fig. 2E is a component block diagram illustrating an exemplary system for managing a photovoltaic arrangement, where a software update is performed for a monitoring module.
Fig. 2F is a component block diagram illustrating an exemplary system for managing a photovoltaic arrangement, where a new monitoring module is installed into a module platform architecture.
Fig. 3 is an illustration of an exemplary computing device-readable medium wherein processor-executable instructions configured to embody one or more of the provisions set forth herein may be comprised.
Fig. 4 illustrates an exemplary computing environment wherein one or more of the provisions set forth herein may be implemented.

### DETAILED DESCRIPTION

The claimed subject matter is now described with reference to the drawings, wherein like reference numerals are generally used to refer to like elements throughout. In the following description, for purposes of explanation, numerous specific details are set forth in order to provide an understanding of the claimed subject matter. It may be evident, however, that the claimed subject matter may be practiced without these specific details. In other instances, structures and devices are illustrated in block diagram form in order to facilitate describing the claimed subject matter.

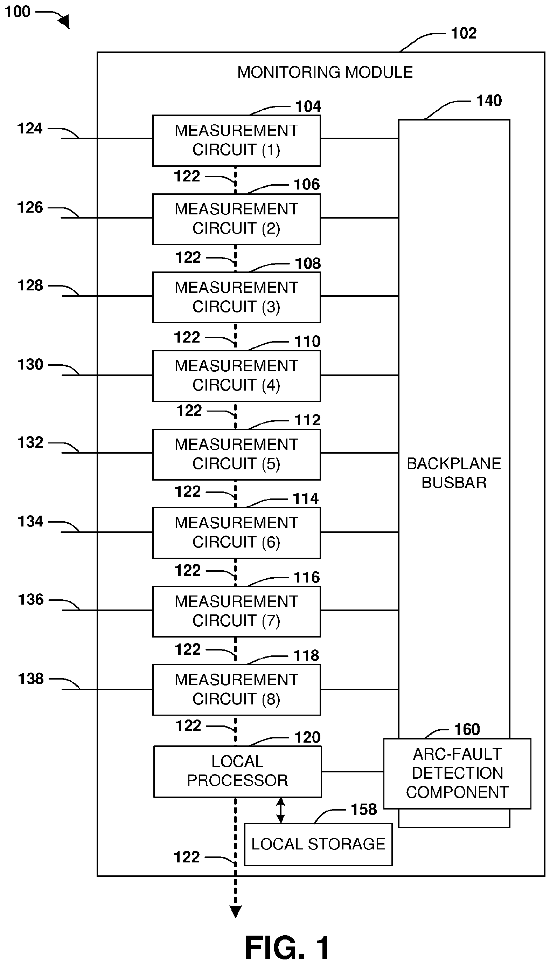

Fig. 1 illustrates an example of a system 100 comprising a monitoring module 102 that may be installed according to a plug and play configuration into a modular platform architecture of a photovoltaic string combiner. For example, the modular platform architecture may have a drop in topology with front facing hardware used to interface with the monitoring module 102. The monitoring module 102 may comprise a local processor 120. The local processor 120 may be configured to store information within local storage 158 of the monitoring module 102. The monitoring module 102 may comprise one or more measurement circuits comprising measurement components (e.g., a current measurement component, a fault detection component, etc.) and/or analog to digital converts, such as a first measurement circuit 104 connected to a first current measurement channel 124 of a first photovoltaic string, a second measurement circuit 106 connected to a second current measurement channel 126 of a second photovoltaic string, a third measurement circuit 108 connected to a third current measurement channel 128 of a third photovoltaic string, a fourth measurement circuit 110 connected to a fourth current measurement channel 130 of a fourth photovoltaic string, a fifth measurement circuit 112 connected to a firth current measurement channel 132 of a fifth photovoltaic string, a sixth measurement circuit 114 connected to a sixth current measurement channel 134 of a sixth photovoltaic string, a seventh measurement circuit 116 connected to a seventh current measurement channel 136 of a seventh photovoltaic string, an eighth measurement circuit 118 connected to an eighth current measurement channel 138 of an eighth photovoltaic string, and/or any other number of measurement circuits. The one or more measurement circuits may be connected to a backplane busbar 140 that provides a powered connection for the monitoring module 102. The one or more measurement circuits may be connected to the local processor 120 by a communication channel 122, such as a voltage isolated digital communication channel. In an example, the measurement circuits may be connected to the photovoltaic strings by one or more fuses.

In an example, the first measurement circuit 104 may comprise a first current measurement component configured to measure current of the first photovoltaic string over the first current measurement channel 124. The first measurement circuit 104 may comprise an analog to digital converter for the first current measurement channel 124 that converts an analog signal from the first current measurement channel 124 to a digital signal. In an example, the first measurement circuit 104 may locally store calibration data within the first current measurement channel 124. In this way, the one or more measurement circuits may collect measurement data of the photovoltaic strings, such as current measurement data, and provide the measurement data to the local processor 120 over the communication channel 122.

The local processor 120 may store the measurement data within the local storage 158 and/or may provide the measurement data over the communication channel 122 to a main controller module of the photovoltaic string combiner. The local processor 120 may be configured to self-detect positional data of the monitoring module 102 within the modular platform architecture (e.g., a position bus of the photovoltaic string combiner may be evaluated to identify an installation slot, of the modular platform architecture, within which the monitoring module 102 is installed) and/or configuration data of the monitoring module 102 (e.g., whether the monitoring module 102 has a grounded configuration or a floating configuration). The local processor 120 may store the positional data and/or the configuration data within the local storage 158 and/or may provide the positional data and/or the configuration data over the communication channel 122 to the main controller module.

In an example, the monitoring module 102 may comprise an arc-fault detection component 160. The arc-fault detection component 160 may be configured to detect at least one of a parallel arc-fault or a series arc-fault associated with a photovoltaic string, the monitoring module 102, and/or the photovoltaic string combiner.

In an example, the local processor 120 may be configured to obtain a temperature measurement of the monitoring module 102. The local processor 120 may be configured to recalibrate the monitoring module 102 based upon the temperature measurement.

In an example, the local processor 120 may be configured to receive a remote software update command such as from the main controller module over the communication channel 122. The local processor 120 may be configured to update the monitoring module 102 based upon the remote software update command (e.g., modification of parameters and/or functionality used to obtain and/or evaluate measurement data).

In may be appreciated that while the monitoring module 102 is described as having current measurement capabilities, that a monitoring module may be configured with a wide variety of capabilities, such as user communication capabilities, fault detection capabilities, photovoltaic string management capabilities, etc.

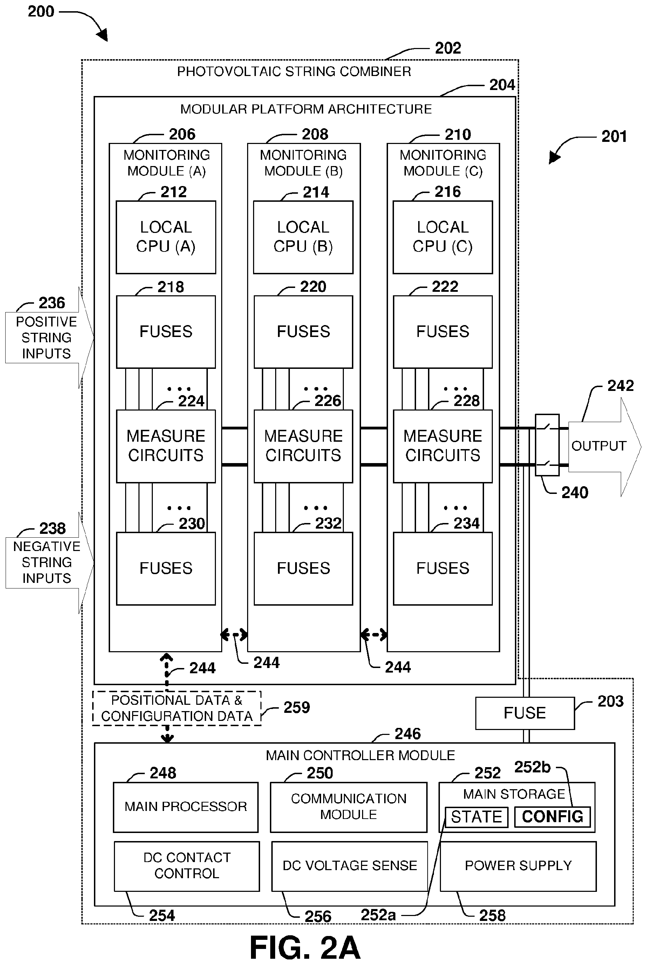

Figs. 2A-2F illustrate examples of a system 201 for photovoltaic arrangement management. Fig. 2A illustrates an example 200 of the system 201 comprising a photovoltaic string combiner 202. The photovoltaic string combiner 202 may be configured to combine a set of photovoltaic strings (e.g., a photovoltaic string comprising a plurality of photovoltaic panels connected in series) of a photovoltaic arrangement, such as in parallel by connecting to positive string inputs 236 and negative string inputs 238 of the set of photovoltaic strings. The photovoltaic string combiner 202 may provide an output 242 from the photovoltaic arrangement such as to an inverter that converts DC power from the photovoltaic arrangement to AC power (e.g., AC power provided to an AC power grid that may supply power to a building). A disconnect 240 may be provided to disconnect the output 242 from the photovoltaic string combiner 202 (e.g., in response to a shutdown command).

The photovoltaic string combiner 202 may comprise a modular platform architecture 204 (e.g., a drop in topology with front facing hardware such that monitoring modules may be relatively easy to swap in and out of the modular platform architecture 204). The modular platform architecture 204 may be configured host one or more monitoring modules interconnected by a communication channel 244, such as a voltage isolated digital communication channel. For example, monitoring modules may be installed in a plug and play manner where a newly installed monitoring module may automatically become self-aware of its operating parameters (e.g., a position of the monitoring module within the modular platform architecture 204, a configuration of the monitoring module such as a grounded configuration or a floating configuration, calibration data of the monitoring module, and/or a role of the monitoring module in managing and monitoring the photovoltaic arrangement) and/or where the photovoltaic string combiner 202 can automatically self-detect and/or adjust management of the photovoltaic arrangement based upon information received from monitoring modules. In an example, a monitoring module (A) 206, a monitoring module (B) 208, a monitoring module (C) 210, and/or any other number of monitoring modules may be installed into the modular platform architecture 204. Power may be provide to the monitoring modules by a backplane busbar.

The monitoring module (A) 206 may comprise a local processor (A) 212 and a first set of measurement circuits 224 (e.g., a current measurement component and an analog to digital converter for a current measurement channel associated with a photovoltaic string) connected to the positive string inputs 236, such as through fuses 218, and connected to the negative string inputs 238, such as through fuses 230 (e.g., positive and negative string inputs for a first set of 8 photovoltaic strings of the photovoltaic arrangement). The monitoring module (B) 208 may comprise a local processor (B) 214 and a second set of measurement circuits 226 connected to the positive string inputs 236, such as through fuses 220, and connected to the negative string inputs 238, such as through fuses 232 (e.g., positive and negative string inputs for a second set of 8 photovoltaic strings of the photovoltaic arrangement). The monitoring module (C) 210 may comprise a local processor (C) 216 and a third set of measurement circuits 228 connected to the positive string inputs 236, such as through fuses 222, and connected to the negative string inputs 238, such as through fuses 234 (e.g., positive and negative string inputs for a third set of 8 photovoltaic strings of the photovoltaic arrangement).

The monitoring module (A) 206 may self-detect (e.g., automatically during installation and/or boot up) first positional data of the monitoring module (A) 206 within the modular platform architecture 204, such as by evaluating a positional bus. The first positional data may indicate that the monitoring module (A) 206 is installed within a first installation slot and is connected to the first set of 8 photovoltaic strings. The monitoring module (A) 206 may self-detect (e.g., automatically during installation and/or boot up) first configuration data such as whether the monitoring module (A) 206 is grounded or floating. The monitoring module (B) 208 may self-detect (e.g., automatically during installation and/or boot up) second positional data of the monitoring module (B) 208 within the modular platform architecture 204, such as by evaluating the positional bus. The second positional data may indicate that the monitoring module (B) 208 is installed within a second installation slot and is connected to the second set of 8 photovoltaic strings. The monitoring module (B) 208 may self-detect (e.g., automatically during installation and/or boot up) second configuration data such as whether the monitoring module (B) 208 is grounded or floating. The monitoring module (C) 210 may self-detect (e.g., automatically during installation and/or boot up) third positional data of the monitoring module (C) 210 within the modular platform architecture 204, such as by evaluating the positional bus. The third positional data may indicate that the monitoring module (C) 210 is installed within a third installation slot and is connected to the third set of 8 photovoltaic strings. The monitoring module (C) 210 may self-detect (e.g., automatically during installation and/or boot up) third configuration data such as whether the monitoring module (C) 210 is grounded or floating. The monitoring module (A) 206, the monitoring module (B) 208, and/or the monitoring module (C) 210 may locally store positional data and/or configuration data (e.g., within local storage, within a current measurement channel, etc.).

The monitoring module (A) 206, the monitoring module (B) 208, and/or the monitoring module (C) 210 may send data 259, such as positional data and/or configuration data self-detected by the monitoring modules, to a main controller module 246 of the photovoltaic string combiner 202. The main controller module 246 may comprise a main processor 248, a DC contact control component 254 (e.g., the main controller module 246 and/or a monitoring module may command the DC contact control component 254 to open in case of a fault such as an over current fault or an over temperature fault, a DC voltage sense component 256 used such as in conjunction with current measurement data to detect an error in operation of a photovoltaic panel, a communication module 250, a power supply 258 used to provide power to the main controller module 246, and/or main storage 252. In an example the main controller module 246 may be connected to the output 242 of the photovoltaic string combiner 202 such as through a fuse 203. The main controller module 246 may receive the data 259 from the monitoring modules over the communication channel 244. The main controller module 246 may store the data 259 within the main storage 252. In an example, the main controller module 246 may evaluate the positional data and the configuration data to identify a modular configuration 252b of the modular platform architecture 204. For example, the modular configuration 252b may indicate that the photovoltaic string combiner 202 comprises 3 grounded monitoring modules and combines 24 photovoltaic strings corresponding to the first, second, and third set of 8 photovoltaic strings.

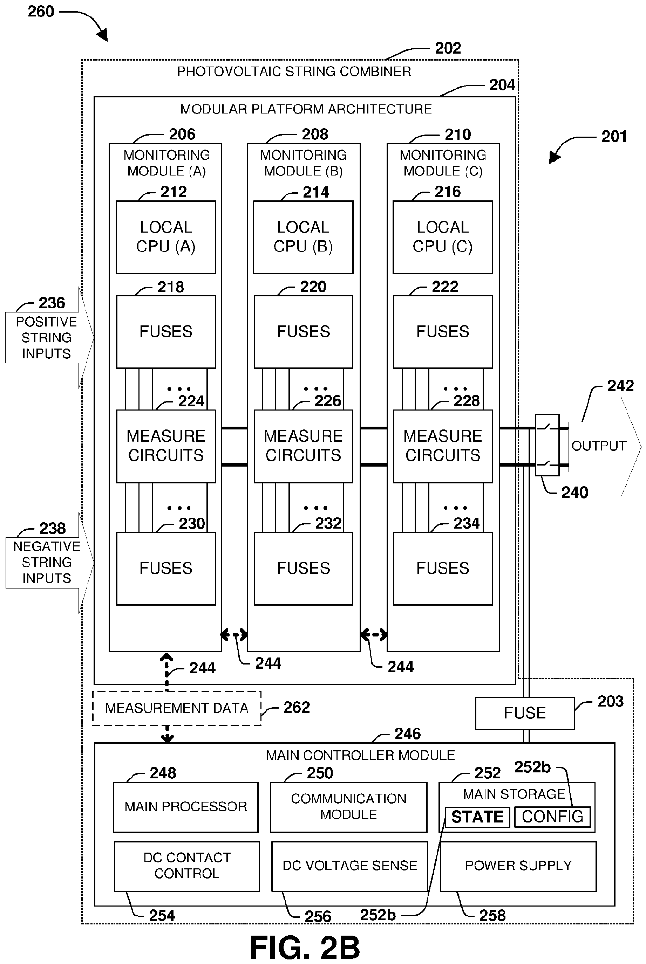

Fig. 2B illustrates an example 260 of the monitoring module (B) 208 providing measurement data 262 to the main controller module 246. For example, the second set of measurement circuits 226 may be configured to obtain measurement data 262, such as current measurements or any other type of measurements (e.g., a voltage measurement, an operating parameter of a photovoltaic panel, a determination as to whether a photovoltaic panel has a fault, etc.), from the second set of 8 photovoltaic strings. In an example, the local processor (B) 214 may locally store the measurement data 262 within the monitoring module (B) 208 (e.g., within local storage or within a current measurement channel). In another example, the local processor (B) 214 may share the measurement data 262 with other monitoring modules by sending the measurement data 262 over the communication channel 244 to the monitoring module (A) 206 and/or the monitoring module (C) 210.

The local processor (B) 214 may send the measurement data 262 over the communication channel 244 to the main controller module 246 (e.g., the communication module 250 may receive the measurement data 262 for access by the main processor 248). The measurement data 262 may be stored within the main storage 252. The main controller module 246 (e.g., the main processor 248, the DC contact control component 254, the DC voltage sense component 256, etc.) may perform post processing on the measurement data 262. In an example, the main controller module 246 may scale the measurement data 262 to create scaled measurement data. In another example, the main controller module 246 may evaluate the measurement data 262 (e.g., and/or the data 259 comprising the positional data and the configuration data of Fig. 2A) to determine a state 252b of the photovoltaic arrangement. The state 252b may indicate whether a fault occurred for the second set of 8 photovoltaic strings, whether the second of 8 photovoltaic strings are operating according to spec or out of spec, and/or other information about the second set of 8 photovoltaic strings (e.g., information about whether there is an arcing or connection issue with a photovoltaic string). In this way, the main controller module 246 may automatically become aware of the modular platform architecture 204 (e.g., a number and configuration of monitoring modules), the photovoltaic arrangement (e.g., a number of photovoltaic strings) and/or operating conditions of the photovoltaic arrangement (e.g., current measurement data, a detected fault, a newly installed photovoltaic panel, a removal of a photovoltaic panel, etc.).

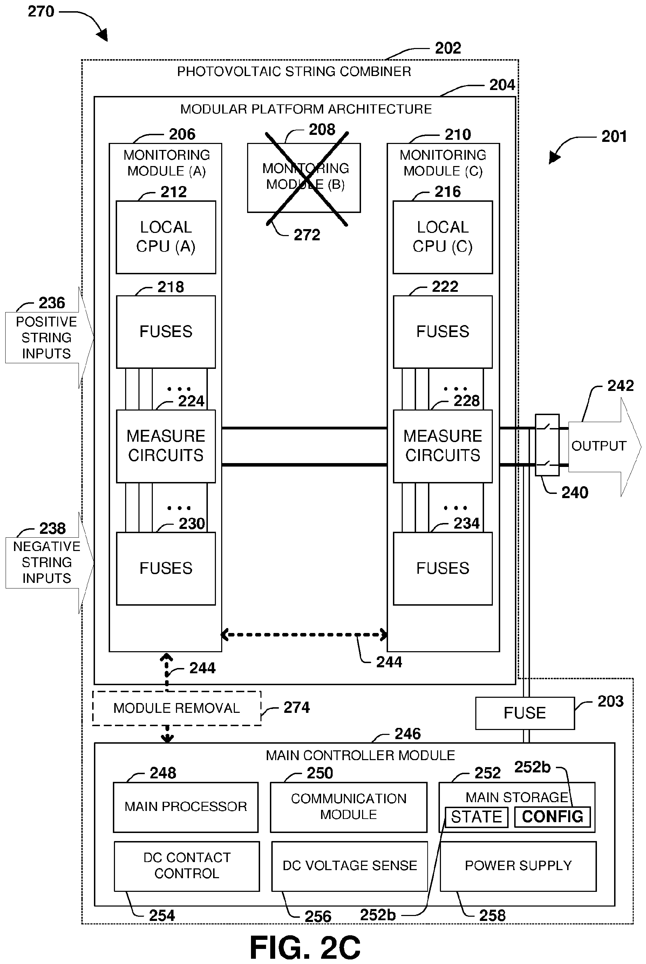

Fig. 2C illustrates an example 270 of the main controller module 246 detecting 274 a removal 272 of the monitoring module (B) 208. Because the modular platform architecture 204 may provide front facing hardware with a drop in topology, a user may easily install or remove monitoring modules from the modular platform architecture 204, such as removing 272 the monitoring module (B) 208 from the modular platform architecture 204. The main controller module 246 may detect 274 the removal 272 based upon various indicators such as a loss of a heartbeat signal from the monitoring module (B) 208, a communication timeout with respect to the monitoring module (B) 208, etc. The main controller module 246 may update the modular configuration 252b based upon the removal 272 to indicate that the modular platform architecture 204 comprises the monitoring module (A) 206 that monitors the first set of 8 photovoltaic strings and the monitoring module (C) 210 that monitors the third set of 8 photovoltaic strings but not the monitoring module (B) 208.

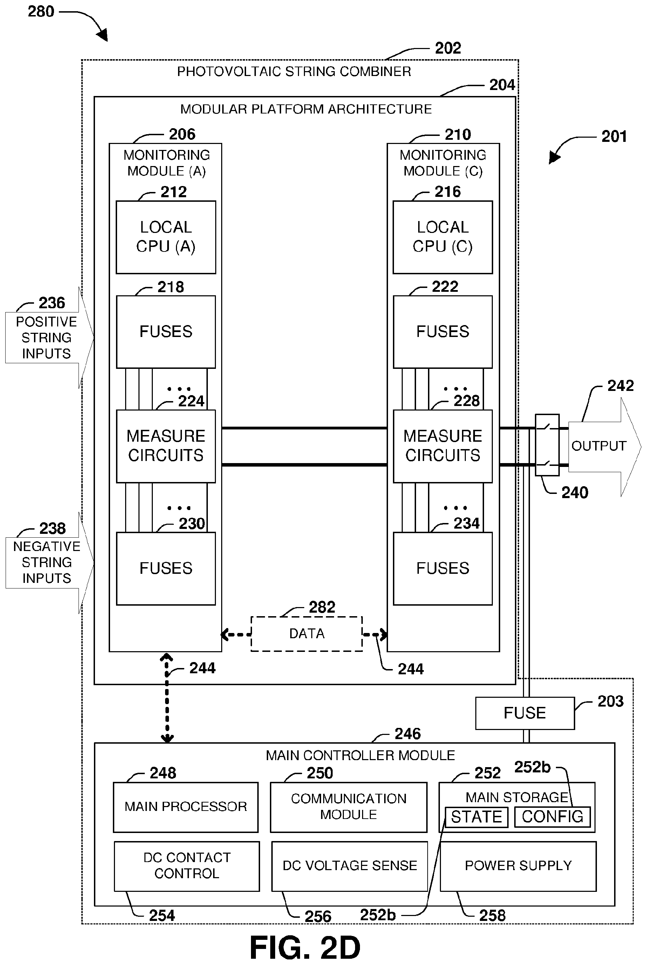

Fig. 2D illustrates an example 280 of the monitoring module (C) 210 sending data 282 to the monitoring module (A) 206 over the communication channel 244. For example, the data 282 may comprise positional data of the monitoring module (C) 210 within the modular platform architecture 204 (e.g., that the monitoring module (C) 210 is installed in the third installation slot and is connected to the third set of 8 photovoltaic strings), configuration data of the monitoring module (C) 210 (e.g., whether the monitoring module (C) 201 has a grounded configuration or a floating configuration), measurement data obtained by the third set of measurement circuits 228, and/or other operational and calibration information of the monitoring module (C) 210. In this way, monitoring modules may locally share information with one another.

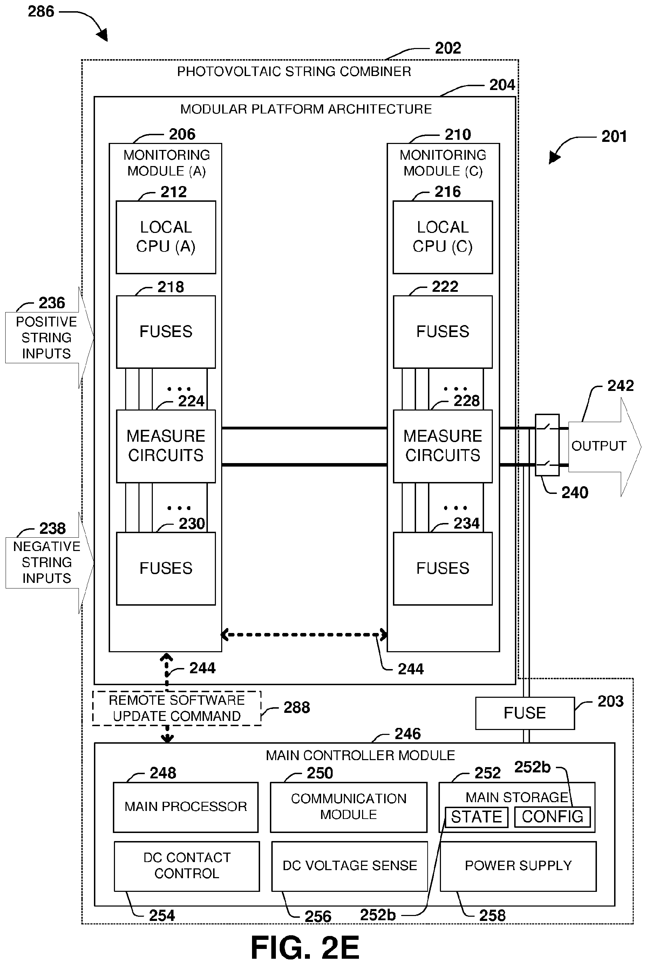

Fig. 2E illustrates an example 286 of the monitoring module (A) 206 performing a software update. For example, the main controller module 246 may receive a remote software update command 288 from a remote source (e.g., the communication module 250 may receive the remote software update command 288 wirelessly or over a network from a computing device). The main controller module 246 may send the remote software update command 288 over the communication channel 244 to the monitoring module (A) 206. The monitoring module (A) 206 may perform the software update based upon the remote software update command 288 (e.g., the monitoring module (A) 206 may update calibration data, parameters and/or functionality used to obtain and evaluate measurement data from photovoltaic strings, configuration data, etc.).

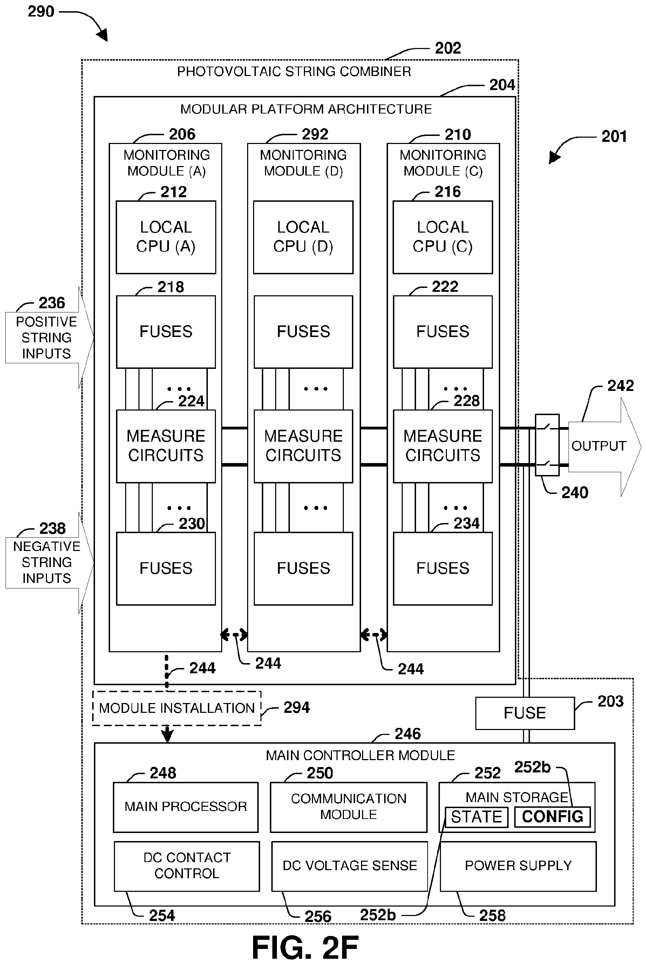

Fig. 2F illustrates an example 290 of the main controller module 246 detecting 294 an installation of a new monitoring module (D) 292 within the modular platform architecture 204. Because the modular platform architecture 204 may provide front facing hardware with a drop in topology, a user may easily install or remove monitoring modules from the modular platform architecture 204, such as installing the new monitoring module (D) 292 into the second installation slot of the modular platform architecture 204 (e.g., as a replacement for the monitoring module (B) 208 that was previously removed from the second installation slot). Upon boot up, a local processor (D) of the new monitoring module (D) 292 may self-detect positional data, indicating that the new monitoring module (D) 292 is installed in the second installation slot and is connected to the second set of 8 photovoltaic strings, (e.g., utilizing a positional bus), and/or configuration data indicating that the new monitoring module (D) 292 has a grounded configuration. The local processor (D) may calibrate a set of measurement circuits for obtaining measurement data from the second set of 8 photovoltaic strings. The local processor (D) may send a notification to the main controller module 246 of the installation of the new monitoring module (D) 292. The notification may comprise the positional data and/or the configuration data. The main controller module 246 may update the modular configuration 252b to indicate that the modular platform architecture 204 now also comprises the monitoring module (D) 292 connected to the second set of 8 photovoltaic strings.

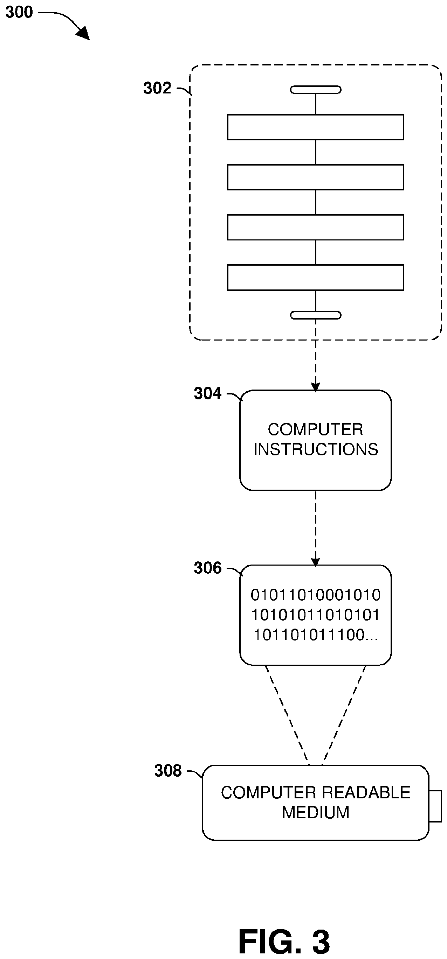

Still another embodiment involves a computer-readable medium comprising processor-executable instructions configured to implement one or more of the techniques presented herein. An example embodiment of a computer-readable medium or a computer-readable device is illustrated in Fig. 3, wherein the implementation 300 comprises a computer-readable medium 308, such as a CD-R, DVD-R, flash drive, a platter of a hard disk drive, etc., on which is encoded computer-readable data 306. This computer-readable data 306, such as binary data comprising at least one of a zero or a one, in turn comprises a set of computer instructions 304 configured to operate according to one or more of the principles set forth herein. In some embodiments, the processor-executable computer instructions 304 are configured to perform a method 302. In some embodiments, the processor-executable instructions 304 are configured to implement a system, such as at least some of the exemplary system 100 of Fig. 1 and/or at least some of the exemplary system 201 of Figs. 2A-2F, for example. Many such computer-readable media are devised by those of ordinary skill in the art that are configured to operate in accordance with the techniques presented herein.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing at least some of the claims.

As used in this application, the terms "component," "module," "system", "interface", and/or the like are generally intended to refer to a computer-related entity, either hardware, a combination of hardware and software, software, or software in execution. For example, a component may be, but is not limited to being, a process running on a processor, a processor, an object, an executable, a thread of execution, a program, and/or a computer. By way of illustration, both an application running on a controller and the controller can be a component. One or more components may reside within a process and/or thread of execution and a component may be localized on one computer and/or distributed between two or more computers.

Furthermore, the claimed subject matter may be implemented as a method, apparatus, or article of manufacture using standard programming and/or engineering techniques to produce software, firmware, hardware, or any combination thereof to control a computer to implement the disclosed subject matter. The term "article of manufacture" as used herein is intended to encompass a computer program accessible from any computer-readable device, carrier, or media.

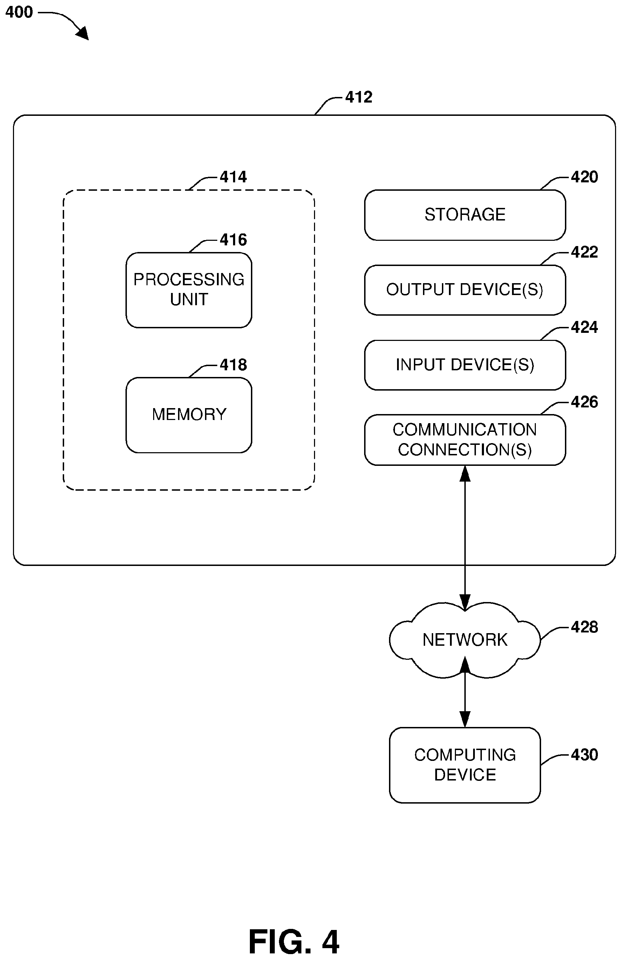

Fig. 4 and the following discussion provide a brief, general description of a suitable computing environment to implement embodiments of one or more of the provisions set forth herein. The operating environment of Fig. 4 is only one example of a suitable operating environment and is not intended to suggest any limitation as to the scope of use or functionality of the operating environment. Example computing devices include, but are not limited to, personal computers, server computers, handheld or laptop devices, mobile devices (such as mobile phones, Personal Digital Assistants (PDAs), media players, and the like), multiprocessor systems, consumer electronics, mini computers, mainframe computers, distributed computing environments that include any of the above systems or devices, and the like.

Although not required, embodiments are described in the general context of "computer readable instructions" being executed by one or more computing devices. Computer readable instructions may be distributed via computer readable media (discussed below). Computer readable instructions may be implemented as program modules, such as functions, objects, Application Programming Interfaces (APIs), data structures, and the like, that perform particular tasks or implement particular abstract data types. Typically, the functionality of the computer readable instructions may be combined or distributed as desired in various environments.

Fig. 4 illustrates an example of a system 400 comprising a computing device 412 configured to implement one or more embodiments provided herein. In one configuration, computing device 412 includes at least one processing unit 416 and memory 418. Depending on the exact configuration and type of computing device, memory 418 may be volatile (such as RAM, for example), non-volatile (such as ROM, flash memory, etc., for example) or some combination of the two. This configuration is illustrated in Fig. 4 by dashed line 414.

In other embodiments, device 412 may include additional features and/or functionality. For example, device 412 may also include additional storage (e.g., removable and/or non-removable) including, but not limited to, magnetic storage, optical storage, and the like. Such additional storage is illustrated in Fig. 4 by storage 420. In one embodiment, computer readable instructions to implement one or more embodiments provided herein may be in storage 420. Storage 420 may also store other computer readable instructions to implement an operating system, an application program, and the like. Computer readable instructions may be loaded in memory 418 for execution by processing unit 416, for example.

The term "computer readable media" as used herein includes computer storage media. Computer storage media includes volatile and nonvolatile, removable and non-removable media implemented in any method or technology for storage of information such as computer readable instructions or other data. Memory 418 and storage 420 are examples of computer storage media. Computer storage media includes, but is not limited to, RAM, ROM, EEPROM, flash memory or other memory technology, CD-ROM, Digital Versatile Disks (DVDs) or other optical storage, magnetic cassettes, magnetic tape, magnetic disk storage or other magnetic storage devices, or any other medium which can be used to store the desired information and which can be accessed by device 412. Computer storage media does not, however, include propagated signals. Rather, computer storage media excludes propagated signals. Any such computer storage media may be part of device 412.

Device 412 may also include communication connection(s) 426 that allows device 412 to communicate with other devices. Communication connection(s) 426 may include, but is not limited to, a modem, a Network Interface Card (NIC), an integrated network interface, a radio frequency transmitter/receiver, an infrared port, a USB connection, or other interfaces for connecting computing device 412 to other computing devices. Communication connection(s) 426 may include a wired connection or a wireless connection. Communication connection(s) 426 may transmit and/or receive communication media.

The term "computer readable media" may include communication media. Communication media typically embodies computer readable instructions or other data in a "modulated data signal" such as a carrier wave or other transport mechanism and includes any information delivery media. The term "modulated data signal" may include a signal that has one or more of its characteristics set or changed in such a manner as to encode information in the signal.

Device 412 may include input device(s) 424 such as keyboard, mouse, pen, voice input device, touch input device, infrared cameras, video input devices, and/or any other input device. Output device(s) 422 such as one or more displays, speakers, printers, and/or any other output device may also be included in device 412. Input device(s) 424 and output device(s) 422 may be connected to device 412 via a wired connection, wireless connection, or any combination thereof. In one embodiment, an input device or an output device from another computing device may be used as input device(s) 424 or output device(s) 422 for computing device 412.

Components of computing device 412 may be connected by various interconnects, such as a bus. Such interconnects may include a Peripheral Component Interconnect (PCI), such as PCI Express, a Universal Serial Bus (USB), firewire (IEEE 1394), an optical bus structure, and the like. In another embodiment, components of computing device 412 may be interconnected by a network. For example, memory 418 may be comprised of multiple physical memory units located in different physical locations interconnected by a network.

Those skilled in the art will realize that storage devices utilized to store computer readable instructions may be distributed across a network. For example, a computing device 430 accessible via a network 428 may store computer readable instructions to implement one or more embodiments provided herein. Computing device 412 may access computing device 430 and download a part or all of the computer readable instructions for execution. Alternatively, computing device 412 may download pieces of the computer readable instructions, as needed, or some instructions may be executed at computing device 412 and some at computing device 430.

Various operations of embodiments are provided herein. In one embodiment, one or more of the operations described may constitute computer readable instructions stored on one or more computer readable media, which if executed by a computing device, will cause the computing device to perform the operations described. The order in which some or all of the operations are described should not be construed as to imply that these operations are necessarily order dependent. Alternative ordering will be appreciated by one skilled in the art having the benefit of this description. Further, it will be understood that not all operations are necessarily present in each embodiment provided herein. Also, it will be understood that not all operations are necessary in some embodiments.

Further, unless specified otherwise, "first," "second," and/or the like are not intended to imply a temporal aspect, a spatial aspect, an ordering, etc. Rather, such terms are merely used as identifiers, names, etc. for features, elements, items, etc. For example, a first object and a second object generally correspond to object A and object B or two different or two identical objects or the same object.

Moreover, "exemplary" is used herein to mean serving as an example, instance, illustration, etc., and not necessarily as advantageous. As used herein, "or" is intended to mean an inclusive "or" rather than an exclusive "or". In addition, "a" and "an" as used in this application are generally be construed to mean "one or more" unless specified otherwise or clear from context to be directed to a singular form. Also, at least one of A and B and/or the like generally means A or B and/or both A and B. Furthermore, to the extent that "includes", "having", "has", "with", and/or variants thereof are used in either the detailed description or the claims, such terms are intended to be inclusive in a manner similar to the term "comprising".

Also, although the disclosure has been shown and described with respect to one or more implementations, equivalent alterations and modifications will occur to others skilled in the art based upon a reading and understanding of this specification and the annexed drawings.

## Claims

1. A system for managing a photovoltaic arrangement, comprising:
a photovoltaic string combiner (202) configured to combine a set of photovoltaic strings of a photovoltaic arrangement, wherein each photovoltaic string comprises a plurality of photovoltaic panels, the photovoltaic string combiner (202) comprising:
a modular platform architecture (204) configured to be connected according to a plug and play configuration to one or more monitoring modules (206, 208, 210) each connected to at least one first photovoltaic string of said photovoltaic strings and interconnected by a communication channel (244), the one or more monitoring modules comprising a first monitoring module (206) comprising a first local processor (212) configured to:
automatically detect at least one of first positional data of the first monitoring module (206) within the modular platform architecture (204), the first positional data of the first monitoring module (206) indicating the installed position of the first monitoring module (206) within the modular platform architecture (204), or first configuration data of the first monitoring module (206), the first configuration data indicating whether the first monitoring module (206) has a grounded configuration or a floating configuration; and
obtain first measurement data from said first photovoltaic string connected to the first monitoring module (206); and
a main controller module (246), connected to the modular platform architecture (204) by the communication channel (244), configured to determine a state of the photovoltaic arrangement based upon at least one of positional data, configuration data, or measurement data received from the one or more monitoring modules (206, 208, 210).

2. The system of claim 1, the photovoltaic string combiner (202) comprising:
an arc-fault detection component (160) configured to detect at least one of a parallel arc-fault or a series arc-fault associated with the photovoltaic arrangement.

3. The system of claim 1, the one or more monitoring modules (206, 208, 210) comprising a second monitoring module configured to:
automatically detect at least one of second positional data of the second monitoring module (208) within the modular platform architecture (204) or second configuration data of the second monitoring module (208);
obtain second measurement data from a second photovoltaic string connected to the second monitoring module (208); and
communicate at least one of the second positional data, the second configuration data, or the second measurement data to the main controller module (246).

4. The system of claim 3, the second monitoring module (208) configured to:
communicate at least one of the second positional data, the second configuration data, or the second measurement data to the first monitoring module (206).

5. The system of claim 1, the first monitoring module (206) comprising local storage (158) within which the first monitoring module (206) stores at least one of the first positional data, the first configuration data, or the first measurement data.

6. The system of claim 1, the main controller module (246) configured to:
determine a number of photovoltaic strings of the photovoltaic arrangement based upon the positional data received from the one or more monitoring modules (206, 208, 210).

7. The system of claim 1, the main controller module (246) configured to:
determine a modular configuration of the modular platform architecture (204) based upon at least one of the positional data or the configuration data received from the one or more monitoring modules (206, 208, 210) .

8. The system of claim 7, the main controller module (246) configured to:
update the modular configuration based upon a determination that a new monitoring module has been installed into the modular platform architecture (204).

9. The system of claim 7, the main controller module (246) configured to:
update the modular configuration based upon a determination that a target monitoring module has been removed from the modular platform architecture (204).

10. The system of claim 1, the communication channel (244) comprising a voltage isolated digital communication channel.

11. The system of claim 1, the photovoltaic string combiner (202) comprising a backplane busbar providing a powered connection between the one or more monitoring modules (206, 208, 210).

12. The system of claim 1, the first monitoring module (206) comprising a current measurement component configured to measure current of the first photovoltaic string over a first current measurement channel.

13. The system of claim 12, the first local processor (212) comprising an analog to digital converter for the first current measurement channel.

14. A method for managing a photovoltaic arrangement as recited in claim 1 comprising a set of photovoltaic strings, wherein each photovoltaic string comprises a plurality of photovoltaic panels, comprising:
utilizing a position bus of a modular platform architecture (204) connected according to a plug and play configuration to one or more monitoring modules (206, 208, 210) each connected to at least one photovoltaic string of said photovoltaic strings to determine positional data of one monitoring module (206) within the modular platform architecture (204), the positional data of the monitoring module indicating the installed position of the monitoring module within the modular platform architecture (204);
identifying configuration data of the monitoring module (206), the configuration data indicating whether the monitoring module (206) has a grounded configuration or a floating configuration;
obtaining current measurement data of a photovoltaic string connected to the monitoring module (206); and
provide at least one of the positional data, the configuration data, or the current measurement data to a main controller module (246) of a photovoltaic string combiner (202).

## Patentansprüche

1. System zum Verwalten einer Photovoltaikanlage, das Folgendes umfasst:
einen Photovoltaikstrangkombinator (202), der dazu ausgestaltet ist, einen Satz von Photovoltaiksträngen einer Photovoltaikanlage zu kombinieren, wobei jeder Photovoltaikstrang eine Vielzahl von Photovoltaikanlagen umfasst, wobei der Photovoltaikstrangkombinator (202) Folgendes umfasst:
eine modulare Plattformarchitektur (204), die zur Verbindung nach einer Plug-und-Play-Anordnung mit einem oder mehreren Überwachungsmodulen (206, 208, 210) ausgestaltet ist, die jedes mit mindestens einem Photovoltaikstrang der Photovoltaikstränge verbunden sind und durch einen Kommunikationskanal (244) miteinander verbunden sind, wobei das eine oder die mehreren Überwachungsmodule ein erstes Überwachungsmodul (206) umfassen, das einen ersten lokalen Prozessor (212) umfasst, der dazu ausgestaltet ist:
automatisch zumindest eines von den Positionsdaten des ersten Überwachungsmoduls (206) in der modularen Plattformarchitektur (204), den ersten Positionsdaten des ersten Überwachungsmoduls (206), die die Einbaulage des ersten Überwachungsmoduls (206) in der modularen Plattformarchitektur (204) anzeigen, oder den ersten Konfigurationsdaten des ersten Überwachungsmoduls (206) zu erfassen, wobei die ersten Konfigurationsdaten anzeigen, ob das erste Überwachungsmodul (206) eine geerdete Konfiguration oder eine unverankerte Konfiguration aufweist; und
die ersten Messdaten von dem ersten Photovoltaikstrang zu erhalten, der mit dem ersten Überwachungsmodul (206) verbunden ist; und
ein Hauptreglermodul (246), das mit der modularen Plattformarchitektur (204) durch den Kommunikationskanal (244) verbunden ist und dazu ausgestaltet ist, einen Zustand der Photovoltaikanlage auf Grundlage von zumindest einem von Positionsdaten, Konfigurationsdaten oder Messdaten, die von dem einen oder den mehreren Überwachungsmodulen (206, 208, 210) empfangen wurden, zu bestimmen.

2. System nach Anspruch 1, wobei der Photovoltaikstrangkombinator (202) Folgendes umfasst:
eine Störlichtbogen-Erfassungskomponente (160), die dazu ausgestaltet ist, zumindest eines von einem parallelen Störlichtbogen oder einem Serienstörlichtbogen, der der Photovoltaikanlage zugeordnet ist, zu erfassen.

3. System nach Anspruch 1, wobei das eine oder die mehreren Überwachungsmodule (206, 208, 210) ein zweites Überwachungsmodul umfassen, das dazu ausgestaltet ist:
automatisch zumindest eines von den zweiten Positionsdaten des zweiten Überwachungsmoduls (208) in der modularen Plattformarchitektur (204) oder den zweiten Konfigurationsdaten des zweiten Überwachungsmoduls (208) zu erfassen;
die zweiten Messdaten von einem zweiten Photovoltaikstrang zu erhalten, der mit dem zweiten Überwachungsmodul (208) verbunden ist; und
zumindest eines von den zweiten Positionsdaten, den zweiten Konfigurationsdaten oder den zweiten Messdaten an das Hauptreglermodul (246) zu kommunizieren.

4. System nach Anspruch 3, wobei das zweite Überwaschungsmodul (208) dazu ausgestaltet ist:
zumindest eines von den zweiten Positionsdaten, den zweiten Konfigurationsdaten oder den zweiten Messdaten an das erste Überwachungsmodul (206) zu kommunizieren.

5. System nach Anspruch 1, wobei das erste Überwachungsmodul (206) lokalen Speicher (158) umfasst, in dem das erste Überwachungsmodul (206) zumindest eines von den ersten Positionsdaten, den ersten Konfigurationsdaten oder den ersten Messdaten speichert.

6. System nach Anspruch 1, wobei das Hauptreglermodul (246) dazu ausgestaltet ist:
eine Anzahl von Photovoltaiksträngen der Photovoltaikanlage auf Grundlage der Positionsdaten zu bestimmen, die von dem einen oder den mehreren Überwachungsmodulen (206, 208, 210) empfangen wurden.

7. System nach Anspruch 1, wobei das Hauptreglermodul (246) dazu ausgestaltet ist:
eine modulare Konfiguration der modularen Plattformarchitektur (204) auf Grundlage von zumindest einem von den Positionsdaten oder den Konfigurationsdaten zu bestimmen, die von dem einen oder den mehreren Überwachungsmodulen (206, 208, 210) empfangen wurden.

8. System nach Anspruch 7, wobei das Hauptreglermodul (246) dazu ausgestaltet ist:
die modulare Konfiguration auf Grundlage einer Bestimmung zu aktualisieren, dass ein neues Überwachungsmodul in der modularen Plattformarchitektur (204) installiert wurde.

9. System nach Anspruch 7, wobei das Hauptreglermodul (246) dazu ausgestaltet ist:
die modulare Konfiguration auf Grundlage einer Bestimmung zu aktualisieren, dass ein Zielüberwachungsmodul aus der modularen Plattformarchitektur (204) entfernt wurde.

10. System nach Anspruch 1, wobei der Kommunikationskanal (244) einen spannungsisolierten digitalen Kommunikationskanal umfasst.

11. System nach Anspruch 1, wobei der Photovoltaikstrangkombinator (202) eine Backplane-Sammelschiene umfasst, die eine spannungsversorgte Verbindung zwischen dem einen oder den mehreren Überwaschungsmodulen (206, 208, 210) bereitstellt.

12. System nach Anspruch 1, wobei das erste Überwachungsmodul (206) eine Strommessungskomponente umfasst, die dazu ausgestaltet ist, Strom des ersten Photovoltaikstrangs über einen ersten Strommesskanal zu messen.

13. System nach Anspruch 12, wobei der erste lokale Prozessor (212) einen Analog-DigitalWandler für den ersten Strommesskanal umfasst.

14. Verfahren zum Verwalten einer Photovoltaikanlage nach Anspruch 1, das einen Satz von Photovoltaiksträngen umfasst, wobei jeder Photovoltaikstrang eine Vielzahl von Photovoltaikanlagen umfasst, umfassend:
Verwenden eines Positionsbusses einer modularen Plattformarchitektur (204), die nach einer Plug-und-Play-Konfiguration mit einem oder mehreren Überwaschungsmodulen (206, 208, 210) verbunden ist, die jedes mit mindestens einem Photovoltaikstrang der Photovoltaikstränge verbunden ist, um Positionsdaten des Überwachungsmoduls (206) in der modularen Plattformarchitektur (204) zu bestimmen, wobei die Positionsdaten des Überwachungsmoduls die Einbauposition des Überwachungsmoduls in der modularen Plattformarchitektur (204) anzeigen;
Ermitteln von Konfigurationsdaten des Überwachungsmoduls (206), wobei die Konfigurationsdaten anzeigen, ob das Überwachungsmodul (206) eine geerdete Konfiguration oder eine unverankerte Konfiguration aufweist;
Erhalten von Strommessdaten eines Photovoltaikstrangs, der mit dem Überwaschungsmodul (206) verbunden ist; und
Bereitstellen von zumindest einem von den Positionsdaten, den Konfigurationsdaten oder den Strommessdaten für ein Hauptreglermodul (246) eines Photovoltaikstrangkombinators (202).

## Revendications

1. Système de gestion d'un agencement photovoltaïque, comprenant :
un combinateur de chaînes photovoltaïques (202) configuré pour combiner un ensemble de chaînes photovoltaïques d'un agencement photovoltaïque, chaque chaîne photovoltaïque comprenant une pluralité de panneaux photovoltaïques, le combinateurs de chaînes photovoltaïques (202) comprenant :
une architecture de plateforme modulaire (204) configurée pour être reliée en fonction d'une configuration prêt à l'emploi à un ou plusieurs modules de surveillance (206, 208, 210), chacun étant relié à au moins une première chaîne photovoltaïque desdites chaînes photovoltaïques et interconnecté par un canal de communication (244), les un ou plusieurs modules de surveillance comprenant un premier module de surveillance (206) comprenant un premier processeur local (212) configuré pour :
détecter automatiquement au moins l'une des premières données de position du premier module de surveillance (206) à l'intérieur de l'architecture de plateforme modulaire (204), les premières données de position du premier module de surveillance (206) indiquant la position installée du premier module de surveillance (206) à l'intérieur de l'architecture de plateforme modulaire (204), ou les premières données de configuration du premier module de surveillance (206), les premières données de configuration indiquant si le premier module de surveillance (206) a une configuration mise à la terre ou une configuration flottante ; et
obtenir des premières données de mesure de ladite première chaîne photovoltaïque reliée au premier module de surveillance (206) ; et
un module de contrôleur principal (246) relié à l'architecture de plateforme modulaire (204) par le canal de communication (244), configuré pour déterminer un état de l'agencement photovoltaïque sur la base au moins de l'une des données de position, des données de configuration ou des données de mesure reçues à partir des un ou de plusieurs modules de surveillance (206, 208, 210).

2. Système selon la revendication 1, le combinateur de chaînes photovoltaïques (202) comprenant :
un composant de détection de défaut d'arc (160) configuré pour détecter au moins l'un d'un défaut d'arc parallèle ou d'un défaut d'arc en série associé à l'agencement photovoltaïque.

3. Système selon la revendication 1, les un ou plusieurs modules de surveillance (206, 208, 210) comprenant un second module de surveillance configuré pour :
détecter automatiquement au moins l'une des secondes données de position du second module de surveillance (208) à l'intérieur de l'architecture de plateforme modulaire (204) ou des secondes données de configuration du second module de surveillance (208) ;
obtenir des secondes données de mesure à partir d'une seconde chaîne photovoltaïque reliée au second module de surveillance (208) ; et
communiquer au moins l'une des secondes données de position, des secondes données de configuration ou des secondes données de mesure au module de contrôleur principal (246).

4. Système selon la revendication 3, le second module de surveillance (208) étant configuré pour :
communiquer au moins l'une des secondes données de position, des secondes données de configuration ou des secondes données de mesure au premier module de surveillance (206).

5. Système selon la revendication 1, le premier module de surveillance (206) comprenant un stockage local (158) à l'intérieur duquel le premier module de surveillance (206) stocke au moins l'une des premières données de position, des premières données de configuration ou des premières données de mesure.

6. Système selon la revendication 1, le module de contrôleur principal (246) étant configuré pour :
déterminer un nombre de chaînes photovoltaïques de l'agencement photovoltaïque sur la base des données de position reçues à partir des un ou plusieurs modules de surveillance (206, 208, 210).

7. Système selon la revendication 1, le module de contrôleur principal (246) étant configuré pour :
déterminer une configuration modulaire de l'architecture de plateforme modulaire (204) sur la base au moins d'une des données de position ou des données de configuration reçues à partir des un ou plusieurs modules de surveillance (206, 208, 210).

8. Système selon la revendication 7, le module de contrôleur principal (246) étant configuré pour :
mettre à jour la configuration modulaire sur la base d'une détermination qu'un nouveau module de surveillance a été installé dans l'architecture de plateforme modulaire (204).

9. Système selon la revendication 7, le module de contrôleur principal (246) étant configuré pour :
mettre à jour la configuration modulaire sur la base d'une détermination qu'un module de surveillance cible a été retiré de l'architecture de plateforme modulaire (204).

10. Système selon la revendication 1, le canal de communication (244) comprenant un canal de communication numérique à tension isolée.

11. Système selon la revendication 1, le combinateur de chaînes photovoltaïques (202) comprenant une barre omnibus de face arrière fournissant une connexion alimentée entre les un ou plusieurs modules de surveillance (206, 208, 210).

12. Système selon la revendication 1, le premier module de surveillance (206) comprenant un composant de mesure de courant configuré pour mesurer le courant de la première chaîne photovoltaïque sur un premier canal de mesure de courant.

13. Système selon la revendication 12, le premier processeur local (212) comprenant un convertisseur analogique-numérique pour le premier canal de mesure de courant.

14. Procédé de gestion d'un agencement photovoltaïque selon la revendication 1 comprenant un ensemble de chaînes photovoltaïques, chaque chaîne photovoltaïque comprenant une pluralité de panneaux photovoltaïques, comprenant :
l'utilisation d'un bus de position d'une architecture de plateforme modulaire (204) reliée en fonction d'une configuration prêt à l'emploi à un ou plusieurs modules de surveillance (206, 208, 210), chacun étant relié à au moins une chaîne photovoltaïque desdites chaînes photovoltaïques pour déterminer des données de position d'un module de surveillance (206) à l'intérieur de l'architecture de plateforme modulaire (204), les données de position du module de surveillance indiquant la position installée du module de surveillance à l'intérieur de l'architecture de plateforme modulaire (204) ;
l'identification de données de configuration du module de surveillance (206), les données de configuration indiquant si le module de surveillance (206) a une configuration mise à la terre ou une configuration flottante ;
l'obtention de données de mesure de courant d'une chaîne photovoltaïque reliée au module de surveillance (206) ; et
la fourniture d'au moins l'une des données de position, des données de configuration ou des données de mesure de courant à un module de contrôleur principal (246) d'un combinateur de chaînes photovoltaïques (202).
